# EUROPEAN PATENT SPECIFICATION

(11) **EP 0 266 275 B1**
(45) Date of publication and mention of the grant of the patent: **29.12.1993**
(21) Application number: 87402438.3
(22) Date of filing: 28.10.1987
(51) Int. Cl.: G03F 1/00

(54) **An X-ray exposure mask for transferring patterns onto a semiconductor wafer**
Röntgenstrahlmaske für Halbleiterbelichtung
Masque pour rayons-X pour l'exposition des plaquettes semi-conductrices

(30) Priority: 28.10.1986 JP 254790/86
(43) Date of publication of application: 04.05.1988
(73) Proprietor: FUJITSU LIMITED, Kawasaki-shi, Kanagawa 211 (JP)
(72) Inventor: Nakagawa, Kenji, Isehara-shi Kanagawa 259-11 (JP)
(74) Representative: Joly, Jean-Jacques

## Description

The present invention relates to an X-ray mask used in a stepper for transferring microscopic patterns onto a semiconductor substrate.

More particularly, this invention relates to an X-ray mask, wherein deformation of mask patterns due to absorber stresses is effectively suppressed.

Photo-lithography technology is widely used for forming patterns on a semiconductor wafer. Using a stepper, the patterns formed on a mask are transferred optically onto a resist layer on the wafer by a step-and-repeat method, in which the semiconductor wafer is moved in X and Y directions and is exposed at specified positions on the wafer.

However, prior art photo-lithography technology using ultra-violet light in the prior art has a limitation on resolution of patterns. Diffraction, interference, or scatter of light causes reduction of resolution. With a trend toward a higher integration of semiconductor devices, X-ray lithography technology becomes gradually used for forming patterns having up to submicron geometries.

The wavelength used in the X-ray lithography is very short and it ranges generally from a few Angstroms to 20 Angstroms. Conventional mask structure for photo-lithography cannot be used, but an X-ray mask having a special structure is used (a mask used in X-ray lithography is abbreviated as X-ray mask). Except that an X-ray source and an X-ray mask are used, other processes are very similar with those applied in conventional photo-lithography technology. However, X-ray lithography and mask technology raise specific problems, which are outlined in "X-ray lithography and mask technology" by Pieter Burggraaf, Semiconductor International, April, 1985, pp. 92-99.

The patterns formed on the X-ray mask are exposed to the X-ray beam and the same patterns are transferred to an X-ray resist layer on a semiconductor wafer, and this process is repeated a plurality of times, moving a stage, on which the wafer is fixed, in X and Y directions. The above process is conventionally designated as a step-and-repeat method for the exposure process, and the apparatus used therefor is known as a stepper.

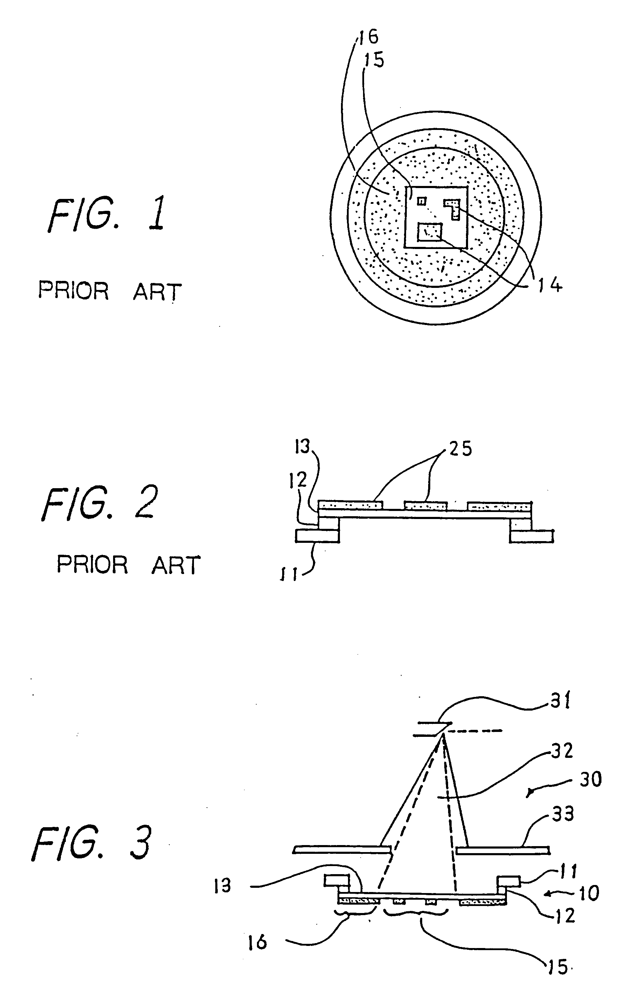

Fig. 1 shows a plan view of a typical X-ray mask, and Fig. 2 shows a schematic cross sectional view thereof. A ring 11 of pyrex glass or ceramic supports a silicon ring 12. In X-ray mask making, a silicon wafer is used as a substrate for forming a membrane 13 at first, and after forming the membrane 13, the most part of the silicon wafer is etched away from a backside leaving the ring-shaped silicon 12, and thus the membrane 13 with controlled tension to achieve flatness is formed, its peripheral region being fixed by silicon ring 12.

The above membrane 13 is formed by growing a layer of inorganic material such as boron nitride (BN), silicon carbide (SiC), or silicon nitride (SiN) on the silicon wafer using a Chemical Vapor Deposition (CVD) method with a thickness of about 1 to 5 microns. The membrane is required to have properties of not incurring deterioration of mechanical strength due to X-ray irradiation and maintaining flatness after the formation of mask patterns.

Mask patterns 14 are formed in X-ray absorbing material 25 such as gold on the central portion of the membrane 13. A general method for forming mask patterns 14 is explained later. In Fig. 1, a single chip pattern is shown in an effective pattern region 15, which is surrounded by a covered region 16. In an actual case, some chip patterns are formed in effective pattern region 15. In the figure, the dotted portion represents the region where the absorbing material forming pattern is remaining.

In an exposure process, the above X-ray mask is installed in a stepper 30 as schematically shown in Fig. 3. X-ray source 31 irradiates X-ray beam 32 through diaphragm 33 onto X-ray mask 10, and a silicon wafer (not shown), having an X-ray resist layer thereon, is exposed to X-ray beam 32 through mask patterns formed in effective pattern region 15. Silicon wafer is moved by a mechanism (also not shown in the figure) after each exposure step. Therefore, the image of a single or a plurality of chip patterns is transferred onto the resist layer in each exposure process.

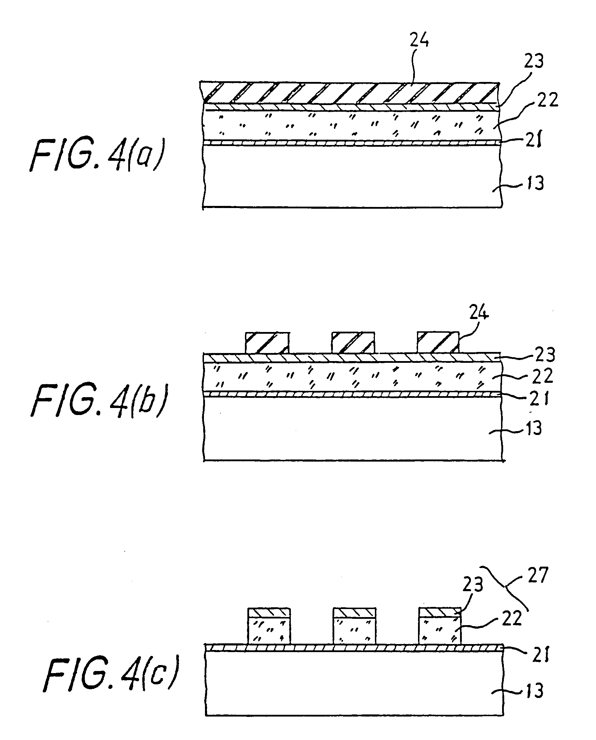

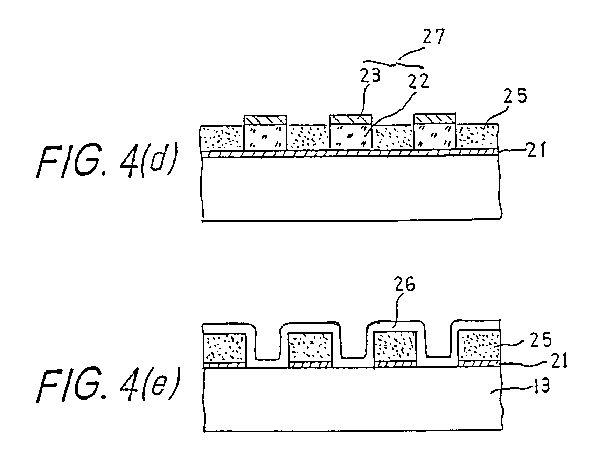

In order to form patterns on the X-ray mask, the following procedure, for example, is typically utilized. Reference is made to Figs. 4(a) through 4(e) which are cross sectional views showing the effective pattern region 15 and correspond to successive sequential steps of the procedure.

In Fig. 4(a), a layer 21 of an electrically conductive material such as tantalum/gold/tantalum (Ta/Au/Ta), or gold/titanium (Au/Ti) is formed on membrane 13, the layer 21 having a thickness of 30 to 50 nm. Layer 21 functions as a plating base in the subsequent step. A polyimide layer 22 having a thickness of 0.5 to 2 microns is formed on conductive layer 21, and further layer 23 of inorganic material, such as silicon dioxide (SiO₂), is formed with a thickness of 50 to 200 nm. Finally, an electron beam (abbreviated as EB hereinafter) resist layer 24 having a thickness of 100 to 500 nm is coated thereon as shown in Fig. 4(a).

EB resist layer 24 is exposed to EB and is patterned as shown in Fig. 4(b). Then, the exposed inorganic layer 23 is etched away by a Reactive Ion Etching (RIE) process using a gas mixture of trifluoromethane (CHF₃) and carbon tetrafluoride (CF₄), and the exposed polyimide layer 22 and remaining EB resist layer 24 are etched away by RIE process using oxygen (O₂) gas, leaving so-called stencil structure 27 forming the desired pattern, as shown in Fig. (4c).

Then, gold plating is performed on the electrically conductive layer 21 and the apertures of stencil 27 are filled up with gold, which functions as an absorber 25 for X-ray beam, as shown in Fig. 4(d). Thereafter, the remaining inorganic layer 23 and polyimide layer 22 of stencil 27 are removed by a RIE process using the same gases as above indicated and the exposed electrically conductive layer 21 is etched away. The removal of the exposed portions of electrically conductive layer 21 is necessary for making these portions translucent to light beam during the alignment procedure of the X-ray mask using alignment marks on the silicon wafer. Finally, a protection layer 26 is provided on the entire mask, and thus the X-ray mask is completed bearing the desired patterns, as shown in Fig. 4(e).

The above described method for forming patterns on an X-ray mask is given only by way of example ; other methods could be applied. For example, an absorber material such as tungsten (W) or tantalum (Ta) can be sputtered or deposited in other ways on the membrane without using the electrically conductive layer, and be subsequently etched for forming the patterns.

The X-ray mask is required to have precise patterns on a flat surface of the membrane and the deformation or deviation from the designed dimensions of patterns should be avoided as much as possible. A membrane having a thickness of 1 to 5 microns is required to have strict properties of flatness and stability during the pattern forming processes and its use in the stepper. The membrane thickness is determined by the material used. For example, the thickness is of 4 to 5 microns when using boron nitride ;
and of about 2 microns, when using silicon carbide or silicon nitride. It depends on the transmission factor for X-ray beam of the membrane material and the property of giving adequate tension to maintain the desired flatness, and is therefore determined experimentally.

Furthermore, the stress generated in the patterned absorber constitutes an important problem. The tensile or compressive stress in the absorber causes displacements of the fringe portions of patterns. This stress force is balanced with the tensile and compressive forces due to the displacements of the absorber and membrane layers.

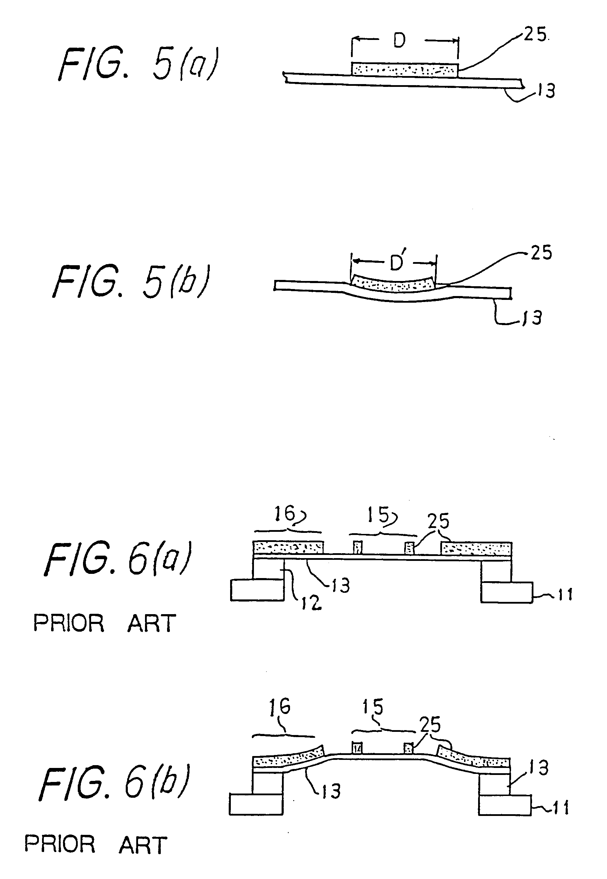

This is illustrated in Figs. 5(a) and 5(b) in a simplified case, wherein an absorber 25 of a simple band-shaped pattern is formed on membrane 13. Fig. 5(a) shows an ideal case with no stress in the absorber 25. The absorber has a length D and shows a flat surface. However, in practice, the absorber 25 undergoes a tensile or compressive stress. When a tensile stress is generated, the absorber 25 shrinks to a length of Dʹ shorter than D, and the membrane 13 and the absorber are deformed a little concave upwardly as shown in Fig. 5(b). If a compressive stress is generated, the absorber elongates.

When the X-ray mask having a patterned absorber in an effective pattern region 15 and a non-patterned absorber in covered region 16, such as shown in Fig. 6(b), is used in the lithography process, the pattern cannot be precisely reproduced on the resist layer of the silicon wafer. Fig. 6(a) shows an ideal case without stress. But Fig. 6(b) shows an X-ray mask wherein both absorbers in the effective pattern region 15 and the covered region 16 undergo a shrinkage stress, deforming the mask surface a little convex upwardly. Although the upward deformation of Fig. 6(b) is somewhat exaggerated, the displacement of the absorber along the mask surface cannot be ignored.

Generally, tensile or compressive stress force F generated in the absorber is balanced with the total compressive and tensile forces along the surface generated by elongation or compression of the absorber and the membrane.

Although efforts have been made to minimize the deformation of the mask patterns, it still remains a difficult problem to be solved.

One prior art attempt at solving the problem of variations in pattern dimensions is disclosed in JP-A-58 78150. Here, a dummy pattern is produced on the glass mask in the region of the necessary pattern so as to obtain a more uniform light distribution over the mask area.

It is therefore a general object of the invention to provide an X-ray mask wherein the deformations of mask patterns due to stresses generated in the absorber are reduced as much as possible, without changing the material used and without special additional processes.

According to the invention, an X-ray exposure mask used for patterning a resist layer formed on a semiconductor wafer using X-ray beam comprises :
a membrane which is translucent to X-ray beam, the surface thereof consisting of a first region centrally located and a second region surrounding said first region;
a first X-ray absorber formed in said first region, with a first group of patterns formed therein by void portions having no absorber material, said patterns being translucent to the X-ray beam and being designed to be transferred onto said semiconductor wafer ; and
a second X-ray absorber formed in said second region, with a second group of patterns formed therein by void portions having no absorber.

Preferably, the density of said second group of patterns is substantially same as the density of said first group of patterns.

As already explained, in the prior art, the membrane of X-ray mask supports absorbers formed in the effective pattern region 15 and in the entirely covered surrounding region 16, as shown in Fig. 1. Here the term "pattern density" A/B is introduced, where A denotes the area effectively covered with absorber material in a specified area, and B denotes the total area. The definition may be reversed to a ratio of the patterned area (B-A) not covered with the absorber material to the total area B. In the covered surrounding region 16 of the prior art mask, the surface of the membrane is completely covered with the absorber, whereby the pattern density is 100% according to the first definition. On the other hand, the pattern density in the effective pattern region 15 ranges from a very small percentage to almost 100%.

After many tests, it has been found that the smaller the difference between pattern densities for the effective pattern region and the surrounding region is, the less deformation of the mask patterns grows.

As already explained, there are two kinds of deformation. One is the displacement along the surface of the mask, and the other is the warp deformation. In the practical application of the X-ray mask, the former is much important. Therefore, emphasis is here more particularly laid on the former type of deformation.

The present invention discloses that the deformation of the X-ray mask can be reduced when the pattern density for the surrounding region is modified preferably to the level of the effective pattern region. This is because the stress forces generated in the absorbers for two regions are then substantially balanced, resulting in a very small displacement of the mask patterns.

The above modification of pattern density is achieved by forming patterns in the surrounding region, which can be performed simultaneously with the formation of patterns in the effective pattern region.

Several kinds of patterns may be formed in the surrounding region 16, as will be apparent from the following description, together with further objects and advantages of the invention.
Fig. 1 shows a plan view of an X-ray mask of the prior art;
Fig. 2 shows a cross sectional view of the X-ray mask of Fig. 1;
Fig. 3 shows a schematic cross sectional view of a stepper, where the X-ray mask is installed;
Figs. 4(a) through 4(e) show a series of sequential steps for fabricating X-ray mask patterns conventionally used ;
Figs. 5(a) and 5(b) show an absorber formed on a membrane respectively in the absence of stress and under the action of stress;
Figs. 6(a) and 6(b) show a typical shape of a prior art X-ray mask, respectively in the absence of stress and under the action of stress;
Figs. 7(a) to 7(c) show figures for analyzing the displacement caused by the absorber in a X-ray mask;
Fig. 8(a) is a plan view of an embodiment of a X-ray mask according to the present invention ;
Fig. 8(b) is a cross sectional view of the mask of Fig. 8(a) ;
Figs. 9 to 11 illustrate patterns formed in the surrounding region of the X-ray mask, according to the present invention ;
Figs. 12(a) and 12(b) illustrate patterns formed in the effective pattern region and surrounding region, respectively, according to the present invention, showing that the pattern densities thereof are substantially similar; and
Figs. 13(a) and 13(b) show other patterns formed in the effective pattern region and the surrounding region, respectively, according to the present invention.

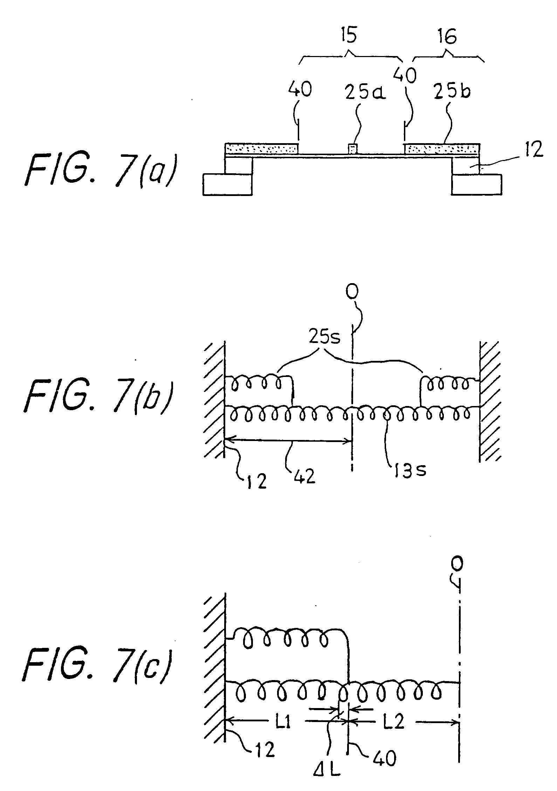

Before describing particular embodiments of the invention, a case of a small pattern density formed in the effective pattern region of an X-ray mask will be first discussed, as an example, and reason for deformation is analyzed. Fig. 7(a) shows a schematic cross sectional view of the X-ray mask for this case, where 25a shows the absorber in the effective pattern region 15 and 25b shows the absorber in the completely covered surrounding region 16. It is assumed that both absorbers 25a and 25b generate tensile stress after formation. The maximum displacement occurs at the fringe portion 40.

Fig. 7(b) shows an equivalent schematic structure for this type of mask, where the lower spring 13s represents membrane 13 and upper spring 25s represents absorber 25b. To show the displacement, a half portion of Fig. 7(b) is sufficient. Therefore, Fig. 7(c), which is used for illustrating the deformation, is an enlarged view of only the left half 42 of Fig. 7(b). On Fig. 7(c), L1 is the distance from the fringe 40 to the wafer ring 12 and L2 is the distance from center O to the fringe 40.

If ΔL is assumed to be the displacement of fringe 40, then the following equations can be derived.

$\text{Fa = σTa,}$
$\text{F1 = (EmTm + EaTa)ΔL/L1,}$
$\text{F2 = EmTmΔL/L2,}$
$\text{Fa = F1 + F2,}$

where Fa is the stress force of absorber 25b ; F1, the compressive force of membrane for portion L1; F2, the tensile force of membrane for portion L2 ; Em, the Young's modulus of the membrane; Ea, the Young's modulus of the absorber ; Tm, the thickness of the membrane ; Ta, the thickness of the absorber, and σ, the stress force per unit cross sectional area of the absorber.

Then the following equation can be obtained ,

$\text{[(EmTm + EaTa)/L1 + EmTm/L2]ΔL = σTa. (1)}$

Substituting actual values of dimensions and material constants, displacement ΔL can be obtained. The above equation (1) can be used for the case when the absorber has complicated patterns by modifying σtoσ x (pattern density). In the case when the pattern densities in the region 13 and in the region 16 are equal, there is no deformation. In the following embodiments, checker patterns are formed in the region 16 for modification.

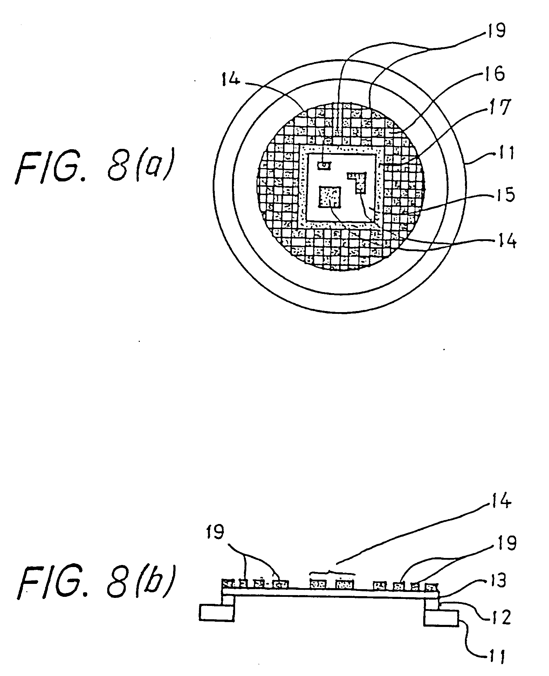

Fig. 8(a) shows a schematic plan view of an embodiment according to the present invention, and Fig. 8(b) shows a cross sectional view thereof. The ring 11 supports a silicon ring 12, on which membrane 13 is formed. To simplify the explanation, one chip pattern consisting of a plurality of patterns 14 is formed in the effective pattern region 15. A band region 17 is provided surrounding the effective pattern region 15, in order to cover, in other words, to shield the fringing area of the effective pattern region from X-ray beam irradiation in the exposure process. Outside the band region 17, extends region 16, where a plurality of small checker patterns 19 are formed.

The reasons for providing a substantial extent of the region 16 outside the effective pattern region 15 are as follows : (1) a membrane flatness for the effective region 15 is required within a submicron order such as 0.2 to 0.3 microns; therefore, the membrane diameter should have enough excess length to obtain uniform tensile stress in region 15, (2) the silicon ring 12 which supports the membrane 13 does not have an ideal flat surface, therefore, a short distance should be provided with regard to the effective pattern region 15, apart from the silicon ring 12.

Because of the uniformly formed absorber of the prior art in surrounding region 16 causes a displacement at the fringe portion of effective pattern region 15, patterns 19 are formed in region 16.

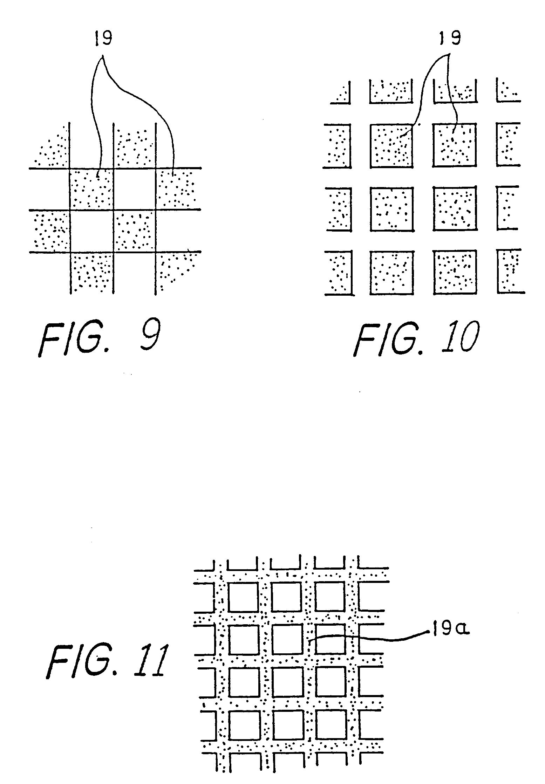

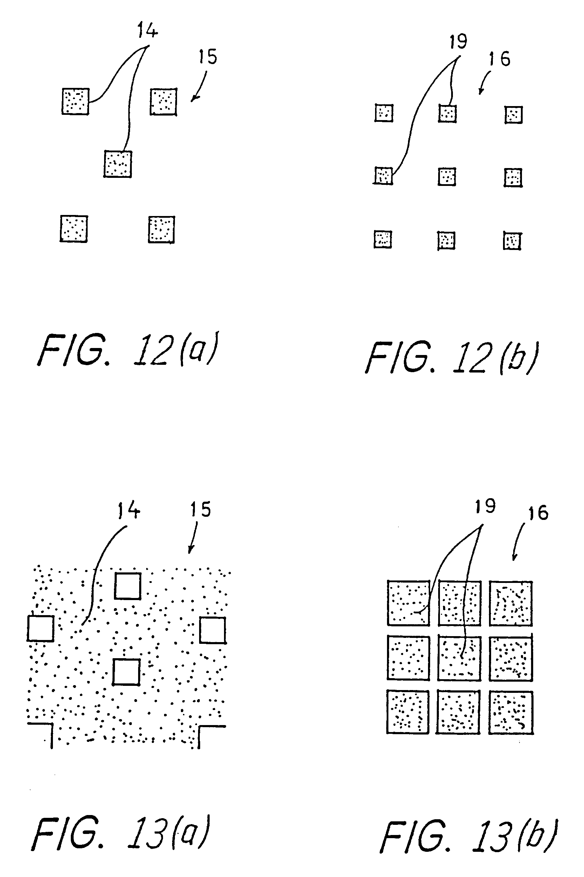

It is preferable that the pattern density in region 16 be selected substantially the same as the one in the effective pattern region 15. Embodiments of practical checker patterns in region 16 are shown in Figs. 9 to 11. Fig. 9 shows a simple checker pattern having a pattern density of 50%. Each absorber pattern 19 contacts with adjacent absorber patterns at its corners. Fig. 10 shows isled rectangular absorber patterns 19 separated from each other by vertical and horizontal void lines without absorber material. And Fig. 11 shows a case where continuous vertical and horizontal absorber lines 19a are formed, whereby the checker patterns are apertures in the form of isled rectangular void portions surrounded by the absorber lines.

The relationships between the pattern densities in effective pattern region 15 and surrounding region 16 are illustrated in Figs. 12(a) and 12(b), and in Figs. 13(a) and 13(b). Fig. 12(a) and Fig. 13(a) show the patterns in effective pattern region 15 to be reproduced on the semiconductor wafer, whereas Fig. 12(b) and Fig. 13(b) show the respective patterns in surrounding region 16 to suppress deformation of the mask, according to the present invention.

The checker pattern 19 shown in Fig. 12(b) is sparse, corresponding to that of Fig. 12(a), where small absorber patterns 14 are formed, and the pattern density of checker patterns 19 of Fig. 13(b) is dense corresponding to that of Fig. 13(a), where small holes are formed in absorber 14. The dotted portions show the absorber patterns formed by gold plating, or by tantalum (Ta) or tungsten (W) etching, or through other ways, as explained previously.

Calculation using equation (1) has proved that a difference between pattern densities in regions 15 and 16 of less than about 30% is sufficient to prevent mask deformation exceeding 0.1 micron. The above result is obtained by substituting the following quantities into equation (1).

$\text{Em = 1 x10¹² dyne/cm², Tm = 4 microns,}$
$\text{Ea = 0.8 x 10¹² dyne/cm², Ta = 1 micron,}$
$\text{L1, L2 = 1.5 cm.}$

Assuming that a stress σ of 2 x 10⁸ dyne/cm² is generated in the absorber, a displacement ΔL = 0.34microns is obtained. This value of deformation occurs when the difference between the pattern densities is 100%. By contrast, if the difference is maintained within 30%, ΔL can be reduced to 0.3 time the above value, i.e. almost 0.1 micron. A deformation of 0.1 micron is acceptable for reproducing patterns precisely using the X-ray lithography method.

It is also preferable that the side dimensions of each checker pattern be selected to be less than 1 mm. The desired pattern density can be easily obtained by a CAD system used in the EB patterning process for the X-ray mask.

## Claims

1. An X-ray exposure mask usable for patterning a resist layer formed on a semiconductor wafer using X-ray beam, said mask comprising :
a membrane (13) which is translucent to X-ray beam, the surface thereof consisting of a first region (15) centrally located and a second region (16) surrounding said first region ;
a first X-ray absorber (14) formed in said first region (15), with a first group of patterns formed therein by void portions having no absorber material, said patterns being translucent to X-ray beam and being designed to be transferred onto said semiconductor wafer; and
a second X-ray absorber (19) formed in said second region (16), with a second group of patterns formed therein by void portions having no absorber material.

2. An X-ray exposure mask according to claim 1, characterized in that the density of said second group of patterns is substantially the same as the density of said first group of patterns.

3. An X-ray exposure mask according to claim 1, characterized in that the difference between densities of said first group of patterns and said second group of patterns is less than 30%.

4. An X-ray exposure mask according to any one of claims 1 to 3, characterized in that said second group of patterns comprises checker patterns.

5. An X-ray exposure mask according to claim 4, characterized in that said second absorber comprises isled rectangular absorber patterns (19) separated from each other by vertical and horizontal void lines without absorber material.

6. An X-ray exposure mask according to claim 4, characterized in that said checker patterns comprise isled rectangular void portions without absorber material and vertical and horizontal absorber lines (19a) surrounding each of said void portions.

## Patentansprüche

1. Eine Röntgenbelichtungsmaske, die zum Mustern einer auf einem Halbleiterwafer gebildeten Resistschicht unter Einsatz von Röntgenstrahlen verwendbar ist, welche Maske umfaßt:
eine Membran (13), die röntgenstrahlendurchlässig ist, deren Oberfläche aus einer ersten Zone (15) besteht, die zentral angeordnet ist, und aus einer zweiten Zone (16), die die genannte erste Zone umgibt;
einen ersten Röntgenstrahlenabsorber (14), der in der genannten ersten Zone (15) gebildet ist, mit einer ersten Gruppe von Mustern, die darin durch leere Abschnitte gebildet sind und kein Absorbermaterial haben, wobei die genannten Muster röntgenstrahlendurchlässig sind und konstruiert sind, um auf den genannten Halbleiterwafer übertragen zu werden; und
einen zweiten Röntgenstrahlenabsorber (19), der in der genannten zweiten Zone (16) gebildet ist, mit einer zweiten Gruppe von Mustern, die darin durch leere Abschnitte gebildet sind und kein Absorbermaterial haben.

2. Ein Röntgenbelichtungsmaske nach Anspruch 1, dadurch gekennzeichnet, daß die Dichte der genannten zweiten Gruppe von Mustern im wesentlichen dieselbe wie die Dichte der genannten ersten Gruppe von Mustern ist.

3. Eine Röntgenbelichtungsmaske nach Anspruch 1, dadurch gekennzeichnet, daß die Differenz zwischen Dichten der genannten ersten Gruppe von Mustern und der genannten zweiten Gruppe von Mustern kleiner als 30 % ist.

4. Eine Röntgenbelichtungsmaske nach einem der Ansprüche 1 bis 3, dadurch gekennzeichnet, daß die genannte zweite Gruppe von Mustern Karomuster umfaßt.

5. Eine Röntgenbelichtungsmaske nach Anspruch 4, dadurch gekennzeichnet, daß der genannte zweite Absorber inselförmige, rechteckige Absorbermuster (19) umfaßt, die durch vertikale und horizontale leere Linien ohne Absorbermaterial voneinander getrennt sind.

6. Eine Röntgenbelichtungsmaske nach Anspruch 4, dadurch gekennzeichnet, daß die genannten Karomuster inselförmige, rechteckige, leere Abschnitte ohne Absorbermaterial umfassen und vertikale und horizontale Absorberlinien (19a) jeden der genannten leeren Abschnitte umgeben.

## Revendications

1. Masque d'exposition à des rayons X, pouvant être utilisé pour réaliser un tracé de motif sur une couche d'agent sensible formée sur une pastille semiconductrice à l'aide d'un faisceau de rayons X, ledit masque comprenant :
une membrane (13) transparente pour le faisceau de rayons X, sa surface étant constituée d'une première région (15) disposée centralement et d'une deuxième région (16) entourant ladite première région ;
un premier élément (14) de matière absorbant les rayons X formé dans ladite première région (15), un premier groupe de motifs étant formés dans cette région par des parties vides dépourvues de matière absorbante, lesdits motifs étant transparents pour le faisceau de rayons X et étant destinés à être transférés sur ladite pastille semiconductrice ; et
un deuxième élément (19) de matière absorbant les rayons X formé dans ladite deuxième région (16), un deuxième groupe de motifs y étant formé par des parties vides dépourvues de matière absorbante.

2. Masque d'exposition à des rayons X selon la revendication 1, caractérisé en ce que la densité dudit deuxième groupe de motifs est sensiblement égale à la densité dudit premier groupe de motifs.

3. Masque d'exposition à des rayons X selon la revendication 1, caractérisé en ce que la différence entre les densités dudit premier groupe de motifs et dudit deuxième groupe de motifs est inférieure à 30 %.

4. Masque d'exposition à des rayons X selon l'une quelconque des revendications 1 à 3, caractérisé en ce que ledit deuxième groupe de motifs comprend des motifs en damier.

5. Masque d'exposition à des rayons X selon la revendication 4, caractérisé en ce que ledit deuxième élément de matière absorbante comprend des motifs (19) de matière absorbante en îlots rectangulaires, qui sont séparés les uns des autres par des lignes verticales et horizontales dépourvues de matière absorbante.

6. Masque d'exposition à des rayons X selon la revendication 4, caractérisé en ce que lesdits motifs en damier comprennent des parties vides en ilôts rectangulaires dépourvues de matière absorbante et des lignes de matière absorbante verticales et horizontales (19a) qui entourent chacune desdites parties vides.
